# DEMANDE DE BREVET EUROPEEN

(11) **EP 3 220 727 A1**
(43) Date de publication de la demande: **20.09.2017**
(21) Numéro de dépôt: 17160905.0
(22) Date de dépôt: 14.03.2017
(51) Int. Cl.: H05K 1/14, H05K 3/34, B23K 35/26, C22C 11/10

(54) **CARTE ÉLECTRONIQUE COMPRENANT UN CIRCUIT INTERCALAIRE EN MATRICE DE BILLES**

(30) Priorité: 15.03.2016 FR 1652178
(71) Demandeur: ALSTOM Transport Technologies, 93400 Saint-Ouen (FR)
(72) Inventeur: REY, William, 69780 MIONS (FR)
(74) Mandataire: Lavoix

(57) **Abrégé**

Carte électronique (50) comportant :
- un circuit imprimé principal (40) comportant des pistes conductrices (44) ;
- un composant électronique (30) ;
- un circuit imprimé intercalaire (10) positionné sur le circuit imprimé principal (40), comportant :
- un substrat (12) ;
- des pistes métalliques (20) situées sur la face supérieure (14) ; et
- des plages métalliques (22) situées sur la face inférieure (16) ;

- une pluralité de billes métalliques (52), situées entre le circuit imprimé intercalaire (10) et le circuit imprimé principal (40).

Les billes métalliques (52) sont soudées aux plages métalliques (22) et aux pistes conductrices (44).

Le circuit imprimé intercalaire (10) reçoit le composant électronique (30) sur sa face supérieure (14).

Les billes métalliques (52) se composent d'un alliage comprenant une teneur massique en plomb supérieure à 85 %.

## Description

La présente invention concerne une carte électronique comportant :
- un circuit imprimé principal comportant des pistes conductrices ;
- au moins un composant électronique ;
- un circuit imprimé intercalaire positionné sur le circuit imprimé principal, comportant :
   - un substrat présentant une face supérieure, une face inférieure et au moins un bord latéral ;
   - au moins une piste métallique située sur la face supérieure, apte à transmettre des signaux électriques ; et
   - au moins une plage métallique située sur la face inférieure, apte à transmettre des signaux électriques ;
- une pluralité de billes métalliques, situées entre le circuit imprimé intercalaire et le circuit imprimé principal, les billes métalliques étant soudées aux plages métalliques et aux pistes conductrices ;
le circuit imprimé intercalaire recevant le ou chaque composant électronique sur sa face supérieure.

Une telle carte électronique résulte du remplacement d'un composant initial par un circuit imprimé intercalaire portant un composant de remplacement, lorsque le composant électronique initial présent dans un circuit imprimé devient obsolète, et qu'il n'existe pas de composant électronique de remplacement dont l'empreinte sur le circuit correspond parfaitement.

La conception et la fabrication d'un nouveau circuit imprimé adapté au composant électronique à jour, est une méthode coûteuse, surtout si elle doit être renouvelée régulièrement.

Ceci est particulièrement important dans les applications ferroviaires, où le remplacement d'un circuit imprimé nécessite des opérations de démontage complexes, et où le temps d'opération d'un dispositif électronique est long par rapport à la vitesse d'évolution des capacités des composants qui les composent.

Il est connu dans ce cas d'utiliser un circuit imprimé intercalaire recevant le composant électronique de remplacement. Ce circuit imprimé intercalaire est connecté par soudage au circuit électronique principal. Une telle opération de remplacement est bien moins coûteuse et plus simple à mettre en oeuvre qu'un retraçage complet.

Par exemple, le document US 6229218 décrit un système d'interconnexion électronique utilisant des contacts sous forme de billes métalliques soudées entre le circuit imprimé principal et le circuit imprimé intercalaire.

Cependant, les conditions d'opérations d'un circuit électrique dans des équipements ferroviaires sont souvent plus dures qu'en électronique classique. Les cartes électroniques doivent donc répondre à des normes de résistance aux contraintes environnementales et à la corrosion plus strictes.

Un but de l'invention est de fournir une carte électronique effectuant le remplacement de composant électronique obsolète en présentant des caractéristiques de résistance aux contraintes environnementales et à la corrosion adaptées à l'utilisation en milieu ferroviaire.

A cet effet, l'invention concerne une carte électronique du type précité, caractérisée en ce que les billes métalliques se composent d'un alliage comprenant une teneur massique en plomb supérieure à 85 %.

La carte électronique selon l'invention peut comprendre l'une ou plusieurs des caractéristiques suivantes, prise(s) isolément ou selon toute combinaison techniquement possible :
- le substrat est réalisé à partir d'un matériau composite comprenant une résine époxy et des fibres de verre ;
- le composant électronique est fixé à la face supérieure du substrat par au moins une soudure située entre une patte du composant électronique et les pistes métalliques ;
- les billes métalliques se composent d'un alliage comprenant une teneur massique en plomb comprise entre 87 % et 91 % ;
- les billes métalliques se composent d'un alliage comprenant une teneur massique en étain comprise entre 8 % et 13 % ;
- les billes métalliques se composent d'un alliage comprenant une teneur massique en argent comprise entre 0 % et 3 % ;
- les pistes métalliques sont reliées électriquement aux plages métalliques par le biais de voies traversant le substrat ;
- la distance entre deux billes métalliques voisines est inférieure ou égale à 2,54 mm;
- le pas entre deux billes métalliques voisines est égal à une valeur prédéterminée comprise entre 0,4 mm et 2,54 mm ; et
- les billes sont soudées aux pistes conductrices avec apport de matière eutectique.

L'invention sera mieux comprise à la lecture de la description qui va suivre ; donnée uniquement à titre d'exemple et faite en référence aux figures annexées, parmi lesquelles :
- la figure 1 est une vue de dessus d'un circuit imprimé intercalaire, portant un composant électronique ; et
- la figure 2 est une vue en coupe d'une partie d'une carte électronique selon l'invention.

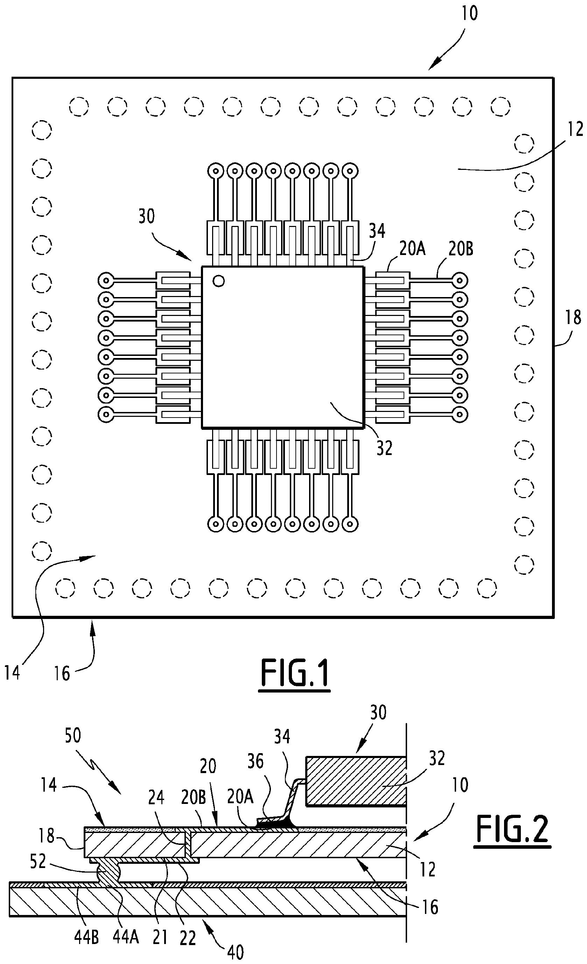

Un circuit imprimé intercalaire 10 est représenté sur la figure 1. Ce circuit imprimé comporte un substrat isolant 12, de la forme d'une plaque sensiblement rectangulaire présentant une face supérieure 14 et une face inférieure 16, ainsi que quatre bords latéraux 18. Le substrat a, par exemple, une longueur et une largeur comprises entre 5 mm et 35 mm selon les applications, et une épaisseur comprise entre 0,8 mm et 1,6 mm.

Le substrat 12 est fabriqué à partir d'un matériau isolant, comme un composite de résine époxy et de fibres de verre tissées. Avantageusement, le matériau isolant est ignifugé par l'ajout d'un composé bromé dans la résine époxy. Par exemple, le matériau composite formant le substrat 12 est de classe FR-4 tel que décrit dans le standard LI 1-1998 (R2011) de la NEMA, « National Electrical Manufacturers Association », dont la température de transition vitreuse est de 180°C.

Le circuit imprimé intercalaire 10 comporte sur la face supérieure 14 du substrat 12 une pluralité de pistes 20 conductrices, par exemple en cuivre, aptes à transmettre des signaux électriques. Dans l'exemple représenté sur la figure 1, le circuit imprimé intercalaire 10 comporte trente-deux pistes 20.

Chaque piste 20 comprend une plage d'accueil 20A et une piste de transmission de signaux électriques 20B.

Le circuit imprimé intercalaire 10 comprend également une pluralité de pistes 21 reliées électriquement à des plages métalliques 22 sur la face inférieure du substrat 12. Les plages métalliques 22 sont conductrices, par exemple en cuivre, de forme ronde.

Les pistes 20 de la face supérieure 14 sont reliées électriquement aux pistes 21 de la face inférieure 16 par le biais de voies 24 traversant le substrat 12.

Les voies 24 sont des conduits percés à travers le substrat 12, débouchant sur la face supérieure 14 et la face inférieure 16, et contenant du cuivre reliant électriquement la piste 20 de la face supérieure 14 à la piste 21 de la face inférieure 16 ou en variante directement à la plage métallique 22 de la face inférieure 16.

En variante, la face inférieure 16 du substrat 12 présente en outre des plages métalliques supplémentaires, non connectées aux pistes 20 de la face supérieure 14.

Comme représenté sur les figures 1 et 2, le circuit imprimé intercalaire 10 reçoit au moins un composant électronique 30 du côté de la face supérieure 14. Le composant électronique 30 est par exemple un circuit intégré comportant un boitier 32 et des pattes métalliques 34. Le boitier 32 contient des équipements électriques aptes à effectuer des fonctions de traitement et de calcul à partir des signaux électroniques d'entrée reçus par le biais de certaines des pattes 34 du composant 30, et à émettre des signaux électriques de sortie par le biais d'autres pattes 34.

Chaque patte 34 du composant électronique 30 est fixée sur une des pistes 20, et notamment sur la plage d'accueil 20A correspondante, par une soudure 36 située entre la patte 34 et la plage d'accueil 20A, comme représenté sur la figure 2.

Comme représenté sur la figure 2, le circuit imprimé intercalaire 10 est positionné sur un circuit imprimé principal 40 pour former une carte électronique 50 à plusieurs niveaux. Le circuit principal 40 présente une pluralité de pistes 44 aptes à transmettre des signaux électriques. Chaque piste 44 comprend une plage d'accueil 44A et une piste de transmission de signaux électriques 44B.

Le circuit imprimé intercalaire 10 est connecté au circuit imprimé principal 40 par l'intermédiaire d'une pluralité de billes métalliques 52, sensiblement sphériques, soudées entre les plages métalliques 22 du circuit imprimé intercalaire 10 et les pistes 44 du circuit imprimé principal 40. Chaque bille métallique 52 est soudée, d'une part, sur la face inférieure 16 proches de l'un des bords latéraux 18 du circuit intercalaire 10 et, d'autre part, sur l'une des plages d'accueil 44A.

Les billes métalliques 52 assurent la fixation mécanique du circuit imprimé intercalaire 10 sur le circuit imprimé principal 40 et la connexion électrique entre les pistes 44 du circuit imprimé principal 40 et celles du circuit imprimé intercalaire 10, c'est-à-dire entre les pistes de transmission 44B et les plages d'accueil 20A.

Dans l'exemple représenté sur la figure 1, la carte électronique 50 comporte quarante-huit billes métalliques 52 réparties également sur les quatre bords latéraux 18. En variante, la carte électronique 50 comporte un nombre différent de billes métalliques 52 réparties sur les quatre bords latéraux 18 ou réparties sur deux bords 18 opposés.

Chaque bille métallique 52 est réalisée à partir d'un alliage comprenant une proportion massique de plomb supérieure à 85%, de préférence comprise entre 87% et 91 %, avantageusement égale à 90%, et une proportion massique d'étain inférieure à 15%, de préférence comprise entre 8% et 13%, avantageusement égale à 10%. En variante, l'alliage comprend également de l'argent, la proportion massique d'argent étant inférieure à 3%, par exemple égale à 2%. La présence d'argent dans l'alliage permet l'amélioration des liaisons métallurgiques et électriques.

La présence de plomb dans les billes métalliques 52 leur confère une température de fusion supérieure à 175°C, notamment proche de 300°C, et confère ainsi au circuit imprimé intercalaire des propriétés de résistance aux hautes températures et aux vibrations mécaniques.

Les billes 52 sont soudées aux plages métalliques 22 sur leur partie supérieure et aux pistes 44 sur leur partie inférieure par un procédé de fusion partielle avec apport de matériau eutectique. Un matériau eutectique est alliage à température de fusion constante, c'est-à-dire qui fond et se solidifie à température constante.

Pour construire la carte électronique 50, le circuit intercalaire 10 est positionné sur le circuit imprimé principal 40 en appui sur les billes 52. L'ensemble est placé dans un four et porté à la température de fusion du matériau eutectique apporté sur les pistes du circuit principal 40, pour obtenir une fusion partielle des billes en superficie et leur soudage aux pistes 44 du circuit imprimé principal 40, c'est-à-dire notamment aux plages d'accueil 44A.

Ce procédé permet de garder une distance minimale d'isolement entre le circuit intercalaire 10 et le circuit principal 40 lors de l'assemblage de la carte électronique 50. Il permet aussi d'avoir un pas faible entre deux billes métalliques 52 voisines sans risques de contacts électriques parasites.

La distance, c'est-à-dire le pas, entre deux billes métalliques 52 voisines est égale à une valeur prédéterminée comprise entre 0,4 mm et 2,54 mm, pour assurer une bonne tenue mécanique de la carte électronique 50 tout en limitant les contraintes locales résultant de dilatation thermique du substrat 12 dues aux variations de température.

La présence de plomb dans le matériau constituant les billes métalliques 52 réduit également la susceptibilité du circuit intercalaire 10 à la corrosion et réduit le risque de casse prématurée de la carte électronique 50.

## Revendications

1. Carte électronique (50) comportant :
- un circuit imprimé principal (40) comportant des pistes conductrices (44) ;
- au moins un composant électronique (30) ;
- un circuit imprimé intercalaire (10) positionné sur le circuit imprimé principal (40), comportant :
- un substrat (12) présentant une face supérieure (14), une face inférieure (16) et au moins un bord latéral (18) ;
- au moins une piste métallique (20) située sur la face supérieure (14), apte à transmettre des signaux électriques ; et
- au moins une plage métallique (22) située sur la face inférieure (16), apte à transmettre des signaux électriques ;
- une pluralité de billes métalliques (52), situées entre le circuit imprimé intercalaire (10) et le circuit imprimé principal (40), les billes métalliques (52) étant soudées aux plages métalliques (22) et aux pistes conductrices (44) ;
le circuit imprimé intercalaire (10) recevant le ou chaque composant électronique (30) sur sa face supérieure (14),
**caractérisée en ce que** les billes métalliques (52) se composent d'un alliage comprenant une teneur massique en plomb supérieure à 85 %.

2. Carte électronique (50) selon la revendication 1, dans laquelle le substrat (12) est réalisé à partir d'un matériau composite comprenant une résine époxy et des fibres de verre.

3. Carte électronique (50) selon l'une quelconque des revendications précédentes, dans laquelle le composant électronique (30) est fixé à la face supérieure (14) du substrat (12) par au moins une soudure située entre une patte (34) du composant électronique (30) et les pistes métalliques (20).

4. Carte électronique (50) selon l'une quelconque des revendications précédentes, dans laquelle les billes métalliques (52) se composent d'un alliage comprenant une teneur massique en plomb comprise entre 87 % et 91 %.

5. Carte électronique selon l'une quelconque des revendications précédentes, dans laquelle les billes métalliques (52) se composent d'un alliage comprenant une teneur massique en étain comprise entre 8 % et 13 %.

6. Carte électronique selon l'une quelconque des revendications précédentes, dans laquelle les billes métalliques (52) se composent d'un alliage comprenant une teneur massique en argent comprise entre 0 % et 3 %.

7. Carte électronique selon l'une quelconque des revendications précédentes, dans laquelle les pistes métalliques (20) sont reliées électriquement aux plages métalliques (22) par le biais de voies (24) traversant le substrat (12).

8. Carte électronique selon l'une quelconque des revendications précédentes, dans laquelle la distance entre deux billes métalliques (52) voisines est inférieure ou égale à 2,54 mm.

9. Carte électronique selon l'une quelconque des revendications précédentes, dans laquelle le pas entre deux billes métalliques (52) voisines est égal à une valeur prédéterminée comprise entre 0,4 mm et 2,54 mm.

10. Carte électronique (50) selon l'une quelconque des revendications précédentes, dans laquelle les billes (52) sont soudées aux pistes conductrices (44) et aux plages métalliques (22) avec apport de matière eutectique.
